# EUROPÄISCHE PATENTSCHRIFT

(11) **EP 0 654 204 B1**
(45) Veröffentlichungstag und Bekanntmachung des Hinweises auf die Patenterteilung: **09.07.1997**
(21) Anmeldenummer: 94906765.6
(22) Anmeldetag: 06.08.1993
(51) Int. Cl.: H05K 13/08, G01R 1/073

(54) **ADAPTEREINRICHTUNG FÜR EINE AUTOMATISCHE PRÜFVORRICHTUNG ZUM PRÜFEN VON SCHALTUNGSPLATINEN**
ADAPTER FOR AN AUTOMATIC INSPECTION DEVICE OF PRINTED CIRCUIT BOARDS
ADAPTATEUR POUR UN DISPOSITIF AUTOMATIQUE DE CONTROLE DES CIRCUITS IMPRIMES

(30) Priorität: 06.08.1992 DE 4226069
(43) Veröffentlichungstag der Anmeldung: 24.05.1995
(73) Patentinhaber: TEST PLUS ELECTRONIC GMBH, D-80337 München (DE)
(72) Erfinder: OTT, Rainer, D-80337 München (DE)
(74) Vertreter: Körber, Wolfhart, Dr. rer.nat.
(86) Internationale Anmeldenummer: EP9302104
(87) Internationale Veröffentlichungsnummer: WO9404015

(56) Entgegenhaltungen:
- EP-A- 0 026 824
- EP-A- 0 030 407
- EP-A- 0 189 179
- EP-A- 0 233 992
- EP-A- 0 237 732
- EP-A- 0 299 232
- EP-A- 0 374 434

## Beschreibung

Die vorliegende Erfindung bezieht sich auf eine Adaptereinrichtung, die zur Prüfung von Schaltungsplatinen in einer vorgegebenen Prüfeinrichtung und für dergleichen ähnliche Anwendungsfälle zu verwenden ist. Insbesondere betrifft die Erfindung Maßnahmen für eine vorteilhafte Halterung der in einer solchen Adaptereinrichtung vorhandenen Kontaktelemente.

Aus der Offenlegungsschrift DE-A40 10 297 gehen Einzelheiten zu Adaptereinrichtungen und Prüfeinrichtungen des Standes der Technik hervor. In der EP-A-0 189 179 ist eine Einrichtung offenbart, bei der Bohrungen mit unterschiedlichen Durchmessern das Halten der Kontaktelemente bewirken. Des weiteren offenbart das Dokument EP-A-0 374 434 eine Einrichtung, bei welcher das Halten der Kontaktelemente mittels bewegbarer Halteschichten bewirkt wird.

In der Technik der Prüfung von Schaltungsplatinen ist es üblich, Adaptereinrichtungen zu verwenden, die im wesentlichen aus einer Trägerplatte und in die Trägerplatte eingesetzten Kontaktelementen bestehen. Zur Kontaktierung einer Schaltungsplatine mit feststehenden Kontaktpunkten sind Feder-Kontaktelemente, auch als Nadelemente bezeichnet, vorgesehen. Zur Kontaktierung mit den schon federnd ausgeführten Kontaktierungspunkten der Prüfeinrichtung genügen dann starre Kontaktelemente, die in dieselbe Trägerplatte eingesetzt sind. Der laterale Versatz eines jeweiligen Kontaktpunktes der Schaltungsplatine gegenüber einem damit zu verbindenden Kontaktpunkt der Prüfeinrichtung wird im Regelfall durch ein Paar solcher Kontaktelemente bewerkstelligt, die z.B. mittels eines Drahtes in Short-Wire-Technik untereinander verbunden sind. Adaptereinrichtungen der sogenannten Long-Wire-Technik haben im Regelfall nur Feder-Kontaktelemente zur Kontaktgabe mit den Schaltungspunkten der Schaltungsplatine und eine längere draht- oder litzenförmige Anschlußleitung. Die Enden dieser Anschlußleitungen sind in einem Kontaktblock vereinigt, der Kontaktelemente aufweisen kann, die vergleichsweise Kontaktelementen einer Adaptereinrichtung der Short-Wire-Technik ausgeführt sind. Auch die hier noch nachfolgend näher zu beschreibende Erfindung ist auch für dieses Kontaktende einer Adaptereinrichtung und auch für ähnlich gelagerte andere Anwendungsfälle geeignet.

Eine zu verwendende Adaptereinrichtung ist auf die jeweils vorgegebene Schaltungsplatine individuell angepaßt und im Regelfall nur für den jeweiligen Typ einer Schaltungsplatine verwendbar. Wird die auf der Platine befindliche Schaltung verändert, muß im Regelfall zumindest eine Veränderung in der Adaptereinrichtung vorgenommen werden, sofern nicht ökonomischer einer neue bzw. neu erstellt Adaptereinrichtung verwendet wird. Kostspielige Teile einer solchen Adaptereinrichtung sind die Kontaktelemente, und zwar insbesondere die Feder-Kontaktelemente. Aber auch aus ökologischen Gründen ist die Wiederverwertbarkeit solcher Kontaktelemente sehr wünschenswert. Es sind bereits im Stand der Technik schon Vorschläge gemacht worden, in welcher Weise Kontaktelemente in einer Träger-platte einerseits auswechselbar, jedoch für die praktische Verwendung sicher fixiert gehaltert werden können. Ein älterer Vorschlag besteht darin, die in die Trägerplatte eingesetzten Kontaktelemente mit einer Einkerbung zu versehen und diese Kontaktelemente mittels einer in diese Kerben eingreifenden Verriegelungsplatte insgesamt festzuhalten. Gegenüber dem Auswechseln in die Trägerplatte eingeschlagener oder eingeklebter Kontaktelemente ist dies bereits ein wesentlicher Fortschritt.

Aufgabe der vorliegenden Erfindung ist es, eine noch einfacher herzustellende und einfacher handzuhabende Ausführung einer Halterungseinrichtung für Kontaktelemente in einer Trägerplatte zu finden, wobei präzise Halterung der Kontaktelemente in der Trägerplatte gewährleistet und vorzugsweise auch Vakuumdichtigkeit an den Stellen in die Trägerplatte eingesetzter Kontaktelemente erzielbar sein muß.

Diese Aufgabe wird für eine Adaptereinrichtung mit den Merkmalen des Patentanspruches 1 gelöst und weitere Ausgestaltungen und Weiterbildungen der Erfindung gehen aus den Unteransprüchen hervor.

Der Erfindung liegen mehrere erfindungsgemäß in Einklang miteinander gebrachte Überlegungen zugrunde. Zum einen ist dies die Wiederverwendung von möglichst vielen Komponenten einer bereits vorhandenen, jedoch später einmal nicht mehr benötigten Adaptereinrichtung. Wegen der individuellen Ausführung der einzelnen Leiterplatten ist eine schon mit einer Vielzahl von Bohrungen versehene Trägerplatte der zugehörigen Prüfvorrichtung im allgemeinen nicht wiederverwendbar, so daß für eine neue Trägerplatte ein neuer Rohling unumgänglich erforderlich ist. Insbesondere gilt dies im Falle einer Halterung der Schaltungsplatine auf einem Chuck mittels Vakuum. Deshalb sollten für die Halterung der Kontaktelemente erforderliche aufwendige Mittel nicht an der Trägerplatte vorgesehen sondern Merkmale der einzelnen als wiederverwendbar auszubildenden Kontaktelemente sein. Die dementsprechende Lösung der Erfindung besteht darin, an der Trägerplatte vorgesehene Mittel zur Halterung der Kontaktelemente vorzusehen, die lediglich in Beschichtungen einer Basisträgerplatte bestehen, wobei letztere vorzugsweise eine Trägerplatte bisheriger, einfachster Art ist. Die Beschichtungen können für viele endgültige Trägerplatten gemeinsam auf eine für die Herstellung bekannter Trägerplatten schon bisher verwendete Rohmaterial-Platte aus z.B. glasfaserverstärktem Epoxidharz großflächig aufgebracht werden, was preislich zusätzlich kaum ins Gewicht fällt. Es sind erfindungsgemäß zwei übereinanderliegende Beschichtungen auf der einen Seite der Basisträgerplatte vorgesehen, von denen die äußere Beschichtung eine solche mit einer im Ergebnis elastischen Wirkung dieser Schicht ist. Die darunter liegende Zwischenschicht aus einem plastischen bzw. elastischem Material besteht dagegen aus sehr nachgiebigem Material. Die Schicht mit der elastischen Wirkung wird als eine Art Feder für das Einrasten eines Wulstes verwendet, der sich erfindungsgemäß am jeweiligen Kontaktelement befindet. Im eingerasteten Zustand liegt dieser Wulst zwischen dem Rand der in der harten Basisträgerplatte vorhandenen Bohrung und dem elastisch federnden Rand des Materials der äußeren Beschichtung. Dieser Wulst des Kontaktelementes wird beim Einsetzen eines Kontaktelementes in die Bohrung der Trägerplatte mit entsprechendem Druck durch die in der äußeren Schicht vorhandene Bohrung hindurchgedrückt, wobei der Durchmesser der Bohrung im Material der äußeren Schicht und/oder das Material im Randbereich der Bohrung dem ausgeübten Druck elastisch nachgibt, nämlich bis dieser Wulst durch diese Bohrung in der zweiten äußeren Schicht hindurchgetreten ist. Mit entsprechender Zugkraft läßt sich das Kontaktelement bzw. dieserWulst wieder aus dieser Einrastung hinter dem Rand der Bohrung in der äußeren zweiten Schicht durch diese Bohrung gegen den elastischen Widerstand des Materials dieser zweiten Schicht herausziehen. Durch Bemessung der Dicke der zweiten Schicht und Wahl des Materials dieser Schicht läßt sich ein Mindestmaß für die Kraft zum Einsetzen und Herausziehen des Kontaktelementes auswählen, wobei dieses Maß groß ist vergleichsweise zu den Kräften, die bei Verwendung der Adaptereinrichtung auf die einzelnen Kontaktelemente axial ausgeübt werden. Damit ist zuverlässige Halterung eines Kontaktelementes in der Träger-Platte gewährleistet.

Eine sonst bisweilen übliche elektrisch leitende Abschirmschicht kann auch bei der vorliegenden Erfindung auf der äußeren Oberfläche, hier der zweiten Schicht, der gesamten Trägerplatte vorgesehen sein. Der am Außenumfang des Kontaktelementes vorzusehende Wulst ist vorzugsweise ein Vorsprunq, der beim Abdrehen der Außenfläche des Kontaktelementes stehengelassen worden ist. Abgesehen vom Drücken eines Wulstes ist auch die spanabhebende Bearbeitung des Kontaktelementes kein relativ gesehen großer Aufwand, da die Kontaktelemente sehr oft wieder verwendet werden können, sich der technische Aufwand somit gut amortisiert.

Weitere Einzelheiten der Erfindung gehen aus der nachfolgenden Beschreibung zu einem Ausführungsbeispiel und zu weiteren Ausgestaltungen der Erfindung hervor.
- Figur 1: zeigt eine Übersichtsdarstellung für eine Adaptereinrichtung in Verbindung mit einer Schaltungsplatine und einer Prüfeinrichtung.
- Figur 2: zeigt eine Detaildarstellung eines Kontaktelementes, wie es in die Bohrung der Trägerplatte eingesetzt und erfindungsgemäß durch Einrasten gehaltert ist.
- Figuren 3 bis 5: zeigen Ausgestaltungen zu Formen des einrastenden Wulstes.

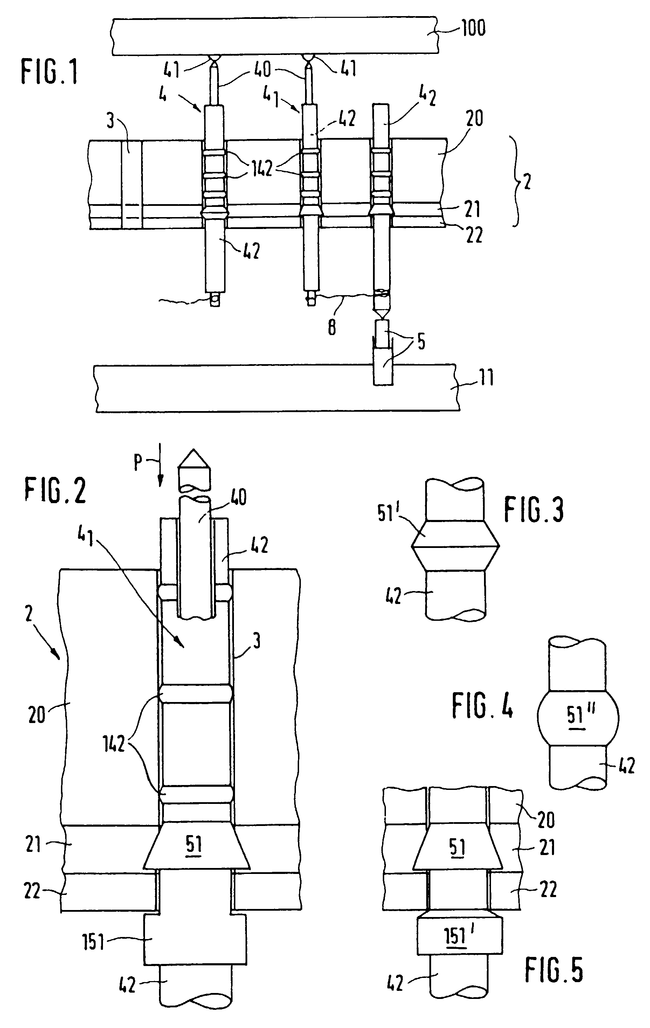

In der Figur 1 ist eine Schnittansicht einer erfindungsgemäßen Adaptereinrichtung 1 wiedergegeben. Eine Schaltungsplatine ist mit 100 bezeichnet, an die mit Hilfe der erfindungsgemäßen Adaptereinrichtung 1 das vorgegebene Kontaktfeld einer (genormten) Prüfvorrichtung 11 anzupassen ist. Mit 41 sind zu prüfende, zu kontaktierende Schaltungspunkte der Schaltungsplatine 100 bezeichnet. In dieser Figur 1 ist eine Adaptereinrichtung dargestellt, bei der die Schaltungsplatine, wie z. B. bei mechanischer Niederhalterung, direkt auf die Nadeln gedrückt wird. Eine bei Vakuumadaptoren notwendige zusätzliche Boardträgerplatte, die aber dem Stand der Technik entspricht, ist zur Vereinfachung nicht mit dargestellt.

Die Adaptereinrichtung 1 besteht im wesentlichen aus einer Trägerplatte 2, die Bohrungen 3 aufweist, in die einzelne Kontaktelemente 4 eingesetzt sind. Zur Kontaktierung mit Schaltungs-Kontaktpunkten 41 der Platine 100 sind im Regelfall Feder-Kontaktelemente 4₁ vorgesehen. Sie besitzen in dem Kontaktelement axial federnd gehaltene Kontaktspitzen 40, die aufgrund der Positionierung des Kontaktelementes 4 in der Trägerplatte 2 mit einem jeweiligen Kontakt-Schaltungspunkt 41 der Platine 100 federnd berührenden elektrischen Kontakt bilden. Das mit 4₂ bezeichnete Kontaktelement ist ein solches, das mit einem im Regelfall federnden Kontaktelement 5 der Prüfvorrichtung 11 axial übereinstimmend in der Trägerplatte 2 positioniert ist. Das Kontaktelement 4₂ hat mit diesem Kontaktelement 5 der Prüfvorrichtung 11 elektrischen Kontakt. Eine in der Figur 1 schematisch dargestellte elektrische Verbindung 8 dient dazu, eine geforderte elektrische Verbindung zwischen dem betreffenden Schaltungspunkt 41 der Platine 100 und dem dazu lateral versetzten Kontaktelement 5 der Prüfvorrichtung 11 zu vollenden. Da dies an sich Stand der Technik ist, zeigt Figur 1 lediglich ein einziges Kontaktelement 4₁, das mit einem Schaltungspunkt 4₁ der Platine Kontaktberührung hat und lediglich ein einziges dazugehöriges Kontaktelement 4₂, das mit der Prüfvorrichtung einen solchen Kontakt aufweist. Die Trägerplatte einer bekannten Adaptereinrichtung enthält eine Vielzahl solcher Kontaktelemente 4₁ und 4₂ in gegebenenfalls auch verschiedenen Ausführungsformen.

Mit 3 ist in Figur 1 eine einzelne Bohrung dargestellt, in die noch kein Kontaktelement eingesetzt ist.

Erfindungsgemäß umfaßt die Trägerplatte 2 eine Basisträgerplatte 20, die die für eine bekannte Kontaktelemente-Trägerplatte 2 erforderliche Steifigkeit und Form-/Maß-Stabilität besitzt. Insbesondere wird als Material für eine solche Trägerplatte bzw. Basisträgerplatte 20 glasfaserverstärktes Epoxidharz verwendet. Ein solches Material läßt sich sehr exakt bohren, so daß die Bohrungen 3 sehr maßgenau sind. Dies ist insbesondere bei sehr dichter Anordnung der Kontaktelemente 4 von Bedeutung.

Bekanntermaßen sind die Kontaktelemente bzw. Hülsen derselben, in denen sich jeweils ein solches Kontaktelement befindet, in die Bohrungen einer solchen Trägerplatte eingeschlagen, eingeklebt und dergleichen befestigt. Eine solche Befestigungsart macht es zumindest schwierig, einzelne oder sämtliche Kontaktelemente aus einer solchen Trägerplatte wieder herauszunehmen, um diese Kontaktelemente z.B. für eine andere Adaptereinrichtung mit anderer Positionierung der Kontaktelemente wiederzuverwenden.

Die erfindungsgemäße Trägerplatte 2 mit ihrer Basisträgerplatte 20 hat auf der in der Figur 1 unteren Seite dieser Basisträgerplatte 20 eine erste Schicht 21 und eine zweite Beschichtung 22, die wie dargestellt übereinanderliegend sind. Diese zwei noch näher zu beschreibenden Schichten 21 und 22 dienen zusammen mit der Basisträgerplatte 20 dazu, die Kontaktelemente 4 erfindungsgemäß so zu haltern, daß die Kontaktelemente gegenüber dem in der praktischen Verwendung einer solchen Adaptereinrichtung jeweils auftretenden Kontakt-Federdruck, dieser ausgehend von der Schaltungsplatine 100 bzw. der Prüfeinrichtung 11, ausreichend sicher axial positioniert bleiben. Andererseits sind diese zwei Schichten 21, 22 gemäß Merkmalen der Erfindung so ausgewählt, daß sie es zulassen, die einzelnen Kontaktelemente 4, z.B. mit zwei Fingern gefaßt, in die Trägerplatte hineinzustecken und aus der Trägerplatte wieder herauszuziehen. Dies ermöglicht z.B. die vielfache Wiederverwendung der Kontaktelemente 4 in für den Einzelfall vorgesehenen mit der individuellen Positionierung von Bohrungen versehenen Trägerplatten 2.

In eine jeweilige individuelle Trägerplatte, erfindungsgemäß bestehend aus der Basisträgerplatte 20 und der ersten und der zweiten Schicht 21, 22, werden entsprechend dem vorgegebenen Verteilungsmuster der Kontaktelemente 5 der Prüfeinrichtung 11 und entsprechend der Verteilung der Schaltungspunkte 41 der jeweiligen Platine 100 die Bohrungen 3 exakt positioniert ausgeführt, wobei es sich um eine durch die drei Bestandteile der Trägerplatte 2 glatt hindurchgehende Bohrung handelt.

Nachfolgend werden der Einfachheit halber an speziellen Ausgestaltungen der Erfindung, wie sie in den weiteren Figuren dargestellt sind, weitere Erläuterungen zur Erfindung gegeben, ohne daß die Allgemeingültigkeit der Erfindung als auf spezielle Ausführungen eingeschränkt anzusehen wäre.

Wie schon in der Allgemeinbeschreibung zur Erfindung dargelegt, übernimmt die Basisträgerplatte 20 die Funktion, die Kontaktelemente 4 in den Bohrungen 3 im wesentlichen spielfrei gehaltert zu positionieren. Figur 2 zeigt ein Feder-Kontaktelement 4₁ mit der Kontaktspitze bzw. dem Nadelteil 40, das zur Kontaktgabe am oberen Ende vorzugsweise angespitzt ist. Es kann dort stattdessen auch ein flächiges Kontaktende der Kontaktspitze bzw. des eigentlichen Nadelteils vorgesehen sein. Diese Kontaktspitze 40 ist (wie - weil bekannt - nicht näher dargestellt) in einer Hülse 42 axial beweglich, jedoch lateral möglichst spielfrei gehaltert. Entsprechend spielfrei ist diese Hülse 42 in die Bohrung 3 der Basisträgerplatte 20 eingesetzt. Hierzu kann diese Hülse auf ihrer Außenseite Vorsprünge, z.B. ringförmige Wülste 142, besitzen, die innig an der Innenseite der Bohrung 3 anliegen. Diese Wülste 142 gestatten aber ein axiales Verschieben der Hülse 42 in der Bohrung 3 der Basisträgerplatte 20.

Zur zuverlässigen Positionierung des Kontaktelementes 4 in Axialrichtung hat diese Hülse 42 einen (weiteren) erfindungsgemäß vorgesehenen ringförmigen Wulst 51, wie er auch aus der Figur 2 (besser als in Figur 1) ersichtlich ist. Anstelle eines solchen ringförmigen Wulstes 51 können im Prinzip auch einzelne, nur Bestandteile eines Ringes bildende Vorsprünge mit der gleichen Funktion vorgesehen sein, für die aber ebenfalls die für die Erfindung gegebenen Bemessungsvorschriften gelten.

Wie aus Figur 2 zu ersehen, befindet sich der erfindungsgemäß vorgesehene ringförmige Wulst 51 bei axial positionierter Lage des Kontaktelementes 4 in der Bohrung 3 der Trägerplatte 2 im Bereich der ersten Schicht 21 derselben. Das Material dieser Schicht hat (vergleichsweise zu den anderen Bestandteilen der Trägerplatte 2) relativ hohe plastische/elastische Nachgiebigkeit, so daß der Wulst beim Einschieben des Kontaktelementes 4 in die Bohrung 3 diese stabile Position allein findet.

Das Kontaktelement 4 wird in diese Position in die Bohrung 3 so eingeschoben, uaß dieser Wulst 51 zunächst durch die in der zweiten Schicht 22 der Trägerplatte 2 befindliche Bohrung 3 hindurchgeschoben wird. Dabei bietet die erfindungsgemäß vorgesehene elastische Wirkung der zweiten Schicht 22 dem Hindurchschieben des Wulstes 51 einen gewissen Widerstand bis der Wulst ganz durch diese Schicht 22 (in die in Figur 2 dargestellte Position) hindurchgeschoben ist. In dieser Position ist diese elastische Wirkung der Schicht 22 wiederum derart effektiv, daß ein Wiederherausschieben des Kontaktelementes 4 bzw. des Wulstes 51 durch die zweite Schicht 22 hindurch unter Einwirkung der im Benutzungsfall der Adaptereinrichtung 1 auftretenden Kräfte ausgeschlossen ist. Mit P ist eine solche vom Schaltungspunkt 41 auf die Spitze des Kontaktelementes 4 ausgeübte, bei der Verwendung der Adaptereinrichtung 1 auftretende Kraft angedeutet.

Die elastische Wirkung der zweiten Schicht 22 ist jedoch in Abstimmung auf die Form und Bemessung des Wulstes 51 derart, daß ein Wiederherausziehen des Kontaktelementes 4 aus der Bohrung 3, d.h. ein Wiederhindurchtreten des Wulstes 51 durch die Bohrung der zweiten Schicht 22 mit entsprechend hoher Zugkrafteinwirkung möglich ist, und zwar ohne das Kontaktelement 4 irgendwie zu beschädigen.

Dieses Kontaktelement kann dann in einer anderen neuen Adaptereinrichtung wiederverwendet werden.

Für diese zweite Schicht 22 kann z.B. ein Material mit entsprechender spezifischer Materialelastizität verwendet werden, z.B. eine Beschichtung aus PVC-Material. Es kann aber auch ein hartes Material, wie z.B. glasfaserverstärktes Epoxidharz (wie z.B. für die Basisträgerplatte 20 verwendet) vorgesehen sein, das jedoch als "Platte" entsprechend dünn bemessen ist. Erfindungswesentlich ist, daß bei gleich großem Durchmesser der Bohrung 3 in der Basisträgerplatte 20 und in beiden Schichten 21 und 22 das Material dieser zweiten Schicht 22 im Bereich der betreffenden Bohrung gegenüber dem entsprechend bemessenen Wulst 51 noch derart elastisch nachgiebig ist, daß einerseits der Wulst 51 durch die Bohrung 3 in dieser zweiten Schicht 22 mit entsprechend bemessenem Kraftaufwand hindurchgeschoben werden kann, andererseits aber das erfindungsgemäße Einrasten durch Hintergreifen der zweiten Schicht 22 mit entsprechender axialer Halterung des Kontaktelementes 4 gewährleistet ist.

Es sei hier darauf hingewiesen, daß das Material der ersten Schicht 21 sogar auch Luft sein kann. Es kann die z.B. aus PVC-Material bestehende zweite Schicht 22 an der Trägerplatte nur punkt- bzw. bereichsweise befestigt, z.B. angeklebt, sein. Es bilden sich dann an den anderen Stellen Luftzwischenräume zwischen der Basisträgerplatte 20 und ihrer zweiten Schicht 22. In einem Bereich einer solchen Luftschicht 21 kann das Einrasten des Wulstes 51 in erfindungsgemäßer Weise erfolgen.

Vorzugsweise wird für die erste Schicht 21 eine entsprechend dick bemessene Klebefolie als Material verwendet, die gleichzeitig auch als Bindemittel für die zweite Schicht an der Basisträgerplatte dient.

Figur 3 zeigt in einer Detaildarstellung eine variierte Form eines erfindungsgemäß vorgesehenen Wulstes. Diese Doppelkegelform 51' ermöglicht es, Einschubkraft und die Kraft zum Wiederherausziehen des Kontaktelementes 4 abweichend zu bemessen. Hinsichtlich der jeweils erforderlichen Kraftwirkung zum Hereinschieben des Kontaktelementes 4 einerseits und zum Herausziehen desselben andererseits ist gegebenenfalls auch die Konsistenz des Materials der ersten Schicht 21 zu berücksichtigen. Auch bei einer symmetrischen Form 51' kann dadurch die Kraft zum Hineinschieben des Kontaktelementes 4 größer sein kann, als die zum Herausziehen.

In Figur 4 ist in Teildarstellung eine Wulstform 51" mit im wesentlichen kreisbogenförmigem Querschnitt gezeigt.

Der Vollständigkeit halber soll auch noch auf einen gegebenenfalls zusätzlichen Wulst oder Vorsprung 151 hingewiesen sein, der speziell für ein Kontaktelement der Art der Kontaktelemente 4₂ vorgesehen ist, die zur Kontaktgabe mit den Kontaktelementen 5 der Prüfeinrichtung 11 vorgesehen sind. Bei diesen Kontaktelementen 4₂ ist die im Betrieb der Adaptereinrichtung 1 auftretende, auf die einzelnen Kontaktelemente einwirkende Kraft in der gleichen Richtung gerichtet, wie es die Kraft zum Einsetzen der Kontaktelemente 4₂ (und 4₁) in die Trägerplatte 2 ist. Dieser zusätzliche Wulst 151 ist ein Widerlager für solche von der Prüfeinrichtung 11 aut Kontaktelemente 4₂ ausgeübte Kraft. Dieser zusätzliche Wulst 151 kann auch für die noch zu beschreibende Abdichtung zweckmäßig sein.

Mit der Lehre der Erfindung ist es anhand der noch nachfolgend gegebenen Hinweise für den Fachmann klar, wie im einzelnen Falle die Materialgrößen für die zweite Schicht 22 und die erste Schicht 21 und die Dickenabmessungen dieser Schichten zu wählen sind, und zwar jeweils in Abstimmung mit Form und Bemessung der Dicke des Wulstes 51. Zum Beispiel ist zu beachten, daß insbesondere im Falle eines weicheren elastischen Materials wie PVC beim Hindurchschieben des Wulstes 51 durch die Bohrung der zweiten Schicht 22 das Material der zweiten Schicht 22 im Bereich dieser Bohrung etwas in Richtung auf die Basisträgerplatte 20 geschoben wird, weil das Material der ersten Schicht stärker nachgiebig ist. Die Höhe des Wulstes 51 muß ggf. gegenüber der Dicke der ersten Schicht 21 um einen gewissen Prozentsatz geringer bemessen sein, damit der maximale Durchmesser des Wulstes 51 auch sicher vollständig durch die Bohrung 3 der zweiten Schicht 22 hindurchtreten kann und gemäß der Erfindung einrastet. Das harte Material der dicken Basisträgerplatte 20 ist für den Wulst 51 praktisch völlig unnachgiebig. Die dabei auftretende geringe Toleranz der axialen Positionierung des Kontaktelementes 4 ist gegenüber den praktischen Anforderungen und insbesondere beim Feder-Kontaktelement vernachlässigbar.

Im praktischen Anwendungsfall hat die Basisträgerplatte 20 z.B. 8 mm Dicke und besteht aus dem schon erwähnten glasfaserverstärkten Epoxidharz. Für die erste Schicht 21 kann insbesondere eine Klebefolie mit einer Dicke von etwa 0,2 mm vorgesehen sein. Die elastische PVC-Schicht als zweite Schicht 22 hat z.B. eine Dicke von 1 mm. Für die Bohrung in der Basisträgerplatte 20 und damit auch in der ersten und in der zweiten Schicht 21, 22, ist ein Maß von 1,7 + 0,01 mm praxisgerecht. Der Maximaldurchmesser des erfindungsgemäß vorgesehenen Wulstes 51 kann dazu 1,75 mm bei sonstigem Durchmesser 1,7 mm des in die Bohrung einzusetzenden Kontaktelementes 4 sein.

Der Vollständigkeit halber sei darauf hingewiesen, daß auch bei der vorliegenden Erfindung Feder-Kontaktelemente mit zwei axial ineinander angeordneten Hülsen verwendet sein können. In diesem Falle ist die äußere Hülse erfindungsgemäß entsprechend der Hülse 42 ausgebildet und mit dem Einrasten des Wulstes 51 im Bereich der ersten Schicht 21 der Trägerplatte 2 axial positioniert gehaltert. Die innere Hülse und das Nadelteil 40 des Feder-Kontaktelementes sind dann auswechselbar in die äußere Hülse eingesetzt, wie dies von Nadel-Feder-Kontaktelementen des Standes der Technik bekannt ist, deren äußere Hülse fest in eine Trägerplatte eingeschlagen bzw. eingeklebt ist. Unabhängig von dieser vorzugsweise Reparaturzwecken dienenden Auswechselbarkeit von lediglich der inneren Hülse und darin federnd angebrachtem Nadelteil kann ein solches Doppelhülsen-Kontaktelement, wie erfindungsgemäß vorgesehen einrastend, in eine erfindungsgemäß vorgesehene Trägerplatte 20, 21, 22 eingesetzt und aus dieser, z.B. zur Wiederverwendung, unbeschädigt wieder herausgezogen werden.

In vielen Fällen wird die Schaltungsplatine 100 durch Unterdruck-Ansaugung auf einer mit einer Abdichtung versehenen durchbohrten Boardträgerplatte gehaltert. Dazu ist es in der Regel erforderlich, daß die Trägerplatte 2 der Adaptereinrichtung mit den darin eingesetzten Kontaktelementen eine vakuumdichte Platte ist. Es ist also erforderlich, daß die Kontaktelemente weitgehend vakuumdicht in die jeweilige Bohrung 3 eingesetzt sind. Mit der Erfindung ist auch diese zusätzliche Bedingung erfüllt, nämlich weil sich das elastische Material, vorzugsweise PVC-Material oder entsprechendes weichelastisches Material, an die in den Figuren untere Kante des erfindungsgemäß vorgesehenen Wulstes 51 unter dem Außenluftdruck anlegt. Es liegt damit eine Abdichtung zwischen dem Material der zweiten Schicht 22 im Bereich ihrer Bohrung 3 und dem unteren Rand des erfindungsyemäß vorgesehenen Wulstes 51 vor. Gegebenenfalls ist für Formgabe und Bemessung des Wulstes 51 auch diese Abdichtung mit zu berücksichtigen. Es kann auch zumindest zusätzlich das Material der ersten Schicht 21 (ausgenommen es ist dies die oben erwähnte Luftschicht) bei entsprechender Materialauswahl zu dieser Abdichtung beitragen. Auf die (zusätzliche) Abdichtung mittels des Wulstes bzw. Ringes 151, insbesondere für Kontaktelemente, die im Betrieb mit einer Druckkraft aus der Richtung der Prüfvorrichtung beaufschlagt sind, ist oben bereits hingewiesen worden.

Eine Ausführungsform mit Kombination eines Wulstes 51 und eines Wulstes 151' zeigt die Figur 5. Diese Kombination dient insbesondere der Abdichtung bei axialer Krafteinwirkung aus jeder der beiden möglichen Richtungen.

Der Begriff "Wulst" ist im Sinne der Erfindung als Sammelbegriff für alle Formen zu verstehen, die für das erfindungsgemäße Einrasten in Verbindung mit insbesondere der zweiten Schicht 22 mit elastischer Wirkung brauchbar sind.

## Patentansprüche

1. Adaptereinrichtung, vorgesehen für eine Prüfeinrichtung (11) für Schaltungsplatinen (100),
mit einer Trägerplatte (2) und
mit stiftförmigen Kontaktelementen (4), die in einer jeweiligen Bohrung (3) der Trägerplatte (2) axial justiert und infolge vorgegebener Passung im wesentlichen lateral spielfrei eingesetzt sind,
wobei diese Trägerplatte (2) eine Mehrschichtplatte (20, 21, 22) ist, bei der auf einer Seite einer aus hartem Kunststoffmaterial bestehenden Basisträgerplatte (20) eine erste Schicht (21) und auf dieser eine zweite Schicht (22) vorgesehen sind, wobei eine jeweilige Bohrung (3) in der Basisträgerplatte (20) und wenigstens in der zweiten Schicht (22) mit gleich großem Durchmesser axial fluchtend gebohrt ist und
wobei das jeweilige Kontaktelement an seinem in der Bohrung (3) eingesetzten Außenumfang einen ringförmigen Wulst (51) aufweist, mit dem dieses Kontaktelement (4) im Bereich der ersten Schicht (21), die zweite Schicht (22) hintergreifend, in der Trägerplatte (2) eingerastet gehaltert ist und wobei die zweite Schicht (22) aus einem aufgrund der Materialeigenschaft und/oder der gewählten Materialdicke dieser Schicht (22) in Bezug auf den Wulst (51) des Kontaktelementes (4) elastische Wirkung im Bereich der jeweiligen Bohrung (3) hat und die erste Schicht (21) vergleichsweise zur zweiten Schicht (22) dort wesentlich höhere Nachgiebigkeit aufweist.

2. Adaptereinrichtung nach Anspruch 1, bei der, bezogen auf den Durchmesser der Bohrung (3), der maximale Wulst-Außendurchmesser und die elastische Wirkung der zweiten Schicht (22) sowie die axiale Höhe des Wulstes (51) und die Dicke der ersten Schicht (21) so aufeinander abgestimmt bemessen sind, daß das eingesteckte Kontaktelement (4) innerhalb vorgegebener Toleranz axial justiert gehalten ist.

3. Adaptereinrichtung nach einem der Ansprüche 1 oder 2, bei der der Wulst (51) eine im wesentlichen kegelstumpfförmige Manteloberfläche aufweist und mit seinem größeren Konusdurchmesser im eingerasteten Zustand der zweiten Schicht (22) zugewandt ist.

4. Adaptereinrichtung nach einem der Ansprüche 1 oder 2, bei der der Wulst die Form eines Doppelkegels (51') oder eine Form mit kreisbogenförmigen Querschnitt (51") hat.

5. Adaptereinrichtung nach einem der Ansprüche 1 bis 4, bei der im eingerasteten Zustand des Wulstes (51, 51', 51") dessen der zweiten Schicht (22) zugewandte Oberfläche derart ausgestaltet ist, daß betriebsmäßig eine Vakuumabdichtung zwischen diesem Teil der Oberfläche des Wulstes und dem gegenüberliegenden Rand des elastisches Materials der zweiten Schicht (22) vorliegt.

6. Adaptereinrichtung nach einem der Ansprüche 1 bis 5, bei der am Kontaktelement (4) ein weiterer Wulst (151, 151') in einem Abstand vom eingerasteten Wulst (51, 51', 51") vorgesehen ist, wobei dieser Abstand im wesentlichen gleich der Dicke der zweiten Schicht 22 ist.

7. Adaptereinrichtung nach einem der Ansprüche 1 bis 6, bei der die erste Schicht (21) als Bindemittel zwischen Basisträgerplatte (20) und zweiter Schicht (22) ausgebildet ist.

8. Adaptereinrichtung nach einem der Ansprüche 1 bis 6, bei der die erste Schicht (21) zwischen Basisträgerplatte (20) und zweiter Schicht (22) zumindest im Bereich der Bohrungen (3) durch Luftzwischenräume gebildet ist.

## Claims

1. An adapter for a test system (11) for circuit boards (100),
characterized by
a support plate (2) and
pin-shaped contact elements (4), that are axially adjusted and, due to the given fitting, inserted practically without lateral leeway in the corresponding bore (3) of the support plate (2);
whereby this support plate (2) is a composite plate (20, 21, 22), characterized by a basis support plate (20) consisting of a hard plastic material, and on one side a first layer (21) and then a second layer (22), whereby a bore is drilled in the support plate (20) and axially aligned in at least the second layer (22), with the same diameter;
whereby the contact element is equipped with a ring-shaped bead (51) on the outer circumference that is inserted into the bore (3); said bead locking the contact element (4) into place in the support plate (2), within the first layer (21), and the second layer (22) holding the contact element, whereby said second layer (22) exhibits an elastic effect in the vicinity of the bore (3) due to the material properties and / or the selected material thickness of this layer with respect to the bead (51) of the contact element (4); and the first layer (21), in comparison to the second layer (22), exhibits significantly higher resilience there.

2. An adapter as in claim 1, wherein the maximum outer diameter of the bead and the elastic effect of the second layer (22) as well as the axial height of the bead (51) and the thickness of the first layer (21) are determined with reference to another and in reference to the diameter of the bore (3), such that the inserted contact element (4) is axially locked into place within specified tolerance.

3. An adapter as in claims 1 or 2, whereby the bead (51) is, for the most part, shaped like a truncated cone, and is orientated such that the larger conical diameter is adjacent to the second layer (22) in the locked position.

4. An adapter as in claims 1 or 2, whereby the bead (51) is shaped like a double cone (51') or in a shape with a circular cross-section (51").

5. An adapter as in claims 1 to 4, whereby, when the bead (51, 51', 51") is in the locked position, the surface of said bead adjacent to the second layer (22) is shaped such, that a vacuum seal exists between this part of the surface of the bead and the adjacent edge of the elastic material of the second layer (22).

6. An adapter as in claims 1 to 5, characterized by an additional bead (151, 151') on the contact element (4) at some distance to the locked bead (51, 51', 51"), whereby this offset is, for the most part, equal to the thickness of the second layer (22).

7. An adapter as in claims 1 to 6, whereby the first layer (21) is used as an adhesive layer between the basis support plate (20) and the second layer (22).

8. An adapter as in claims 1 to 6, whereby the first layer (21) between the basis support plate (20) and the second layer (22) consists of air pockets, at least in the vicinity of the bores (3).

## Revendications

1. Adaptateur, prévu pour un dispositif de vérification (11) de plaquettes de circuits imprimés (100), comportant une plaque de support (2) et comportant des éléments de contact (4) en forme de broches, qui sont ajustés chacun axialement dans un perçage (3) respectif de la plaque de support (2) et sont insérés, à la suite d'un ajustement donné, sensiblement sans jeu latéral, dans lequel cette plaque de support (2) est une plaque multicouche (20, 21, 22), dans laquelle sont prévues, sur un côté d'une plaque de support de base (20), réalisée dans une matière plastique dure, une première couche (21) et sur celle-ci, une deuxième couche (22), dans lequel un perçage (3) respectif pratiqué dans la plaque de support de base (20) et au moins dans la deuxième couche (22), avec un diamètre de même grandeur, sont percés axialement alignés et dans lequel l'élément de contact respectif présente, sur son pourtour extérieur inséré dans le perçage (3), un bourrelet (51) annulaire, avec lequel cet élément de contact (4) est maintenu, dans la zone de la première couche (21), accroché dans la plaque de support (2), en passant derrière la deuxième couche (22) et dans lequel la deuxième couche (22) possède un effet élastique, dans la zone du perçage (3) respectif, en raison de la propriété du matériau et/ou de l'épaisseur choisie pour le matériau de cette couche (22), par rapport au bourrelet (51) de l'élément de contact (4), et la première couche (21) présente une souplesse sensiblement plus grande que la deuxième couche (22).

2. Adaptateur selon la revendication 1, dans lequel, par rapport au diamètre du perçage (3), le diamètre extérieur maximal du bourrelet et l'effet élastique de la deuxième couche (22) ainsi que la hauteur axiale du bourrelet (51) et l'épaisseur de la première couche (21) ont des dimensions adaptées les unes aux autres de manière que l'élément de contact (4) enfiché est maintenu axialement ajusté, à l'intérieur d'une tolérance donnée.

3. Adaptateur selon l'une des revendications 1 ou 2, dans lequel le bourrelet (51) présente une surface d'enveloppe sensiblement en forme de tronc de cône et est tourné vers la deuxième couche (22), avec son plus grand diamètre de cône, à l'état accroché.

4. Adaptateur selon l'une des revendications 1 ou 2, dans lequel le bourrelet a la forme d'un double cône (51') ou la forme d'une section transversale en arc de cercle (51").

5. Adaptateur selon l'une des revendications 1 à 4, dans lequel à l'état accroché du bourrelet (51, 51', 51") sa surface, tournée vers la deuxième couche (22), est telle que de par le fonctionnement, il existe une étanchéité au vide entre cette partie de la surface du bourrelet et le bord opposé du matériau élastique de la deuxième couche (22).

6. Adaptateur selon l'une des revendications 1 à 5, dans lequel est prévu, sur l'élément de contact (4), un autre bourrelet (151, 151'), à distance du bourrelet (51, 51', 51") accroché à l'intérieur, cette distance étant sensiblement égale à l'épaisseur de la deuxième couche (22).

7. Adaptateur selon l'une des revendications 1 à 6, dans lequel la première couche (21) est un liant entre la plaque de support de base (20) et la deuxième couche (22).

8. Adaptateur selon l'une des revendications 1 à 6, dans lequel la première couche (22) est formée par des interstices d'air, entre la plaque de support de base (20) et la deuxième couche (22), au moins dans la zone des perçages (3).
